(19) Europäisches Patentamt
European Patent Office
Office européen des brevets

(11) Publication number: **0 116 776 A1**

# (12) EUROPEAN PATENT APPLICATION

(21) Application number: 83307808.2

(22) Date of filing: 21.12.83

(51) Int. Cl.³: **H 03 K 5/24**
H 03 K 3/288, H 03 K 13/175

(30) Priority: 27.12.82 JP 230600/82
24.12.82 JP 232261/82

(43) Date of publication of application: 29.08.84 Bulletin 84/35

(84) Designated Contracting States: DE FR GB NL

(71) Applicant: SONY CORPORATION
7-35 Kitashinagawa 6-Chome Shinagawa-ku
Tokyo 141(JP)

(72) Inventor: Sekino, Takeo
c/o Patent Division Sony Corporation
7-35 Kitashinagawa-6 Shinagawa-ku Tokyo(JP)

(72) Inventor: Takeda, Masashi
c/o Patent Division Sony Corporation
7-35 Kitashinagawa-6 Shinagawa-ku Tokyo(JP)

(74) Representative: Thomas, Christopher Hugo et al,
D Young & Co 10 Staple Inn
London WC1V 7RD(GB)

## (54) Latched comparator circuits.

(57) A latched comparator circuit in which a voltage comparing operation and a latch operation are repeatedly carried out at every sampling period, comprises a plurality of voltage comparators ($A_{i2}$) supplied with one analog input signal commonly and a plurality of different reference voltages respectively, one of the voltage comparators ($A_{i2}$) being selected at every sampling period and output terminals of the voltage comparators ($A_{i2}$) being connected in common, a latch circuit (21) directly supplied with a common output of the voltage comparators ($A_{i2}$) and carrying out a latch operation in synchronism with a sampling period, and output terminal of the latch circuit (21) being commonly connected to the voltage comparators ($A_{i2}$) and also being connected through a resistor ($R_L$) to a power source (Vcc).

FIG. 9

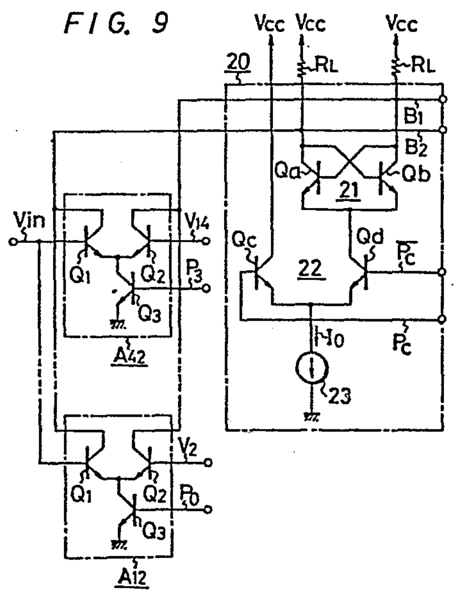


EP 0 116 776 A1

Croydon Printing Company Ltd.

# LATCHED COMPARATOR CIRCUITS

This invention relates to latched comparator circuits. Such latched comparator circuits may, for example, be used in high speed analog-to-digital (A/D) converters.

In general, a high speed A/D converter is constructed as a parallel A/D converter as shown in Figure 1 of the accompanying drawings or as a serial-to-parallel A/D converter shown in Figure 2 of the accompanying drawings.

More specifically, the parallel A/D converter shown in Figure 1 is for 8-bit A/D conversion and comprises 255 voltage comparators $A_1$ to $A_{255}$ in which an analog input voltage $V_{in}$ is compared with 255-step reference voltages $V_1$ to $V_{255}$, respectively. The compared outputs therefrom are all supplied to an encoder 1 from which digital outputs $D_0$ to $D_7$ of eight bits are derived.

On the other hand, the serial-to-parallel A/D converter shown in Figure 2 is also for use in 8-bit A/D conversion, in which the input voltage $V_{in}$ is supplied to a 4-bit parallel A/D converter 2 at the first stage which derives digital outputs $D_7$ to $D_4$ of the more significant four bits. The digital outputs $D_7$ to $D_4$ of the more significant four bits are supplied to a digital-to-analog (D/A) converter 3, in which they are converted to an analog voltage $V_m$. A difference voltage $V_{in}-V_m$ between the input voltage $V_{in}$ and the analog voltage $V_m$ derived from a differential amplifier 4 is supplied to a 4-bit parallel A/D converter 5 at the next stage, from which digital outputs $D_3$ to $D_0$ of the less significant four bits are derived.

However, the known parallel A/D converter shown in Figure 1 requires $(2^n-1)$ voltage comparators to convert the analog input voltage $V_{in}$ to digital outputs of n bits, so the number of circuit elements is large, thereby causing the chip size to become large and power consumption to be increased when the A/D converter is formed as an integrated circuit (IC).

Whereas, the known serial-to-parallel A/D converter shown in Figure 2 requires only $(2^m + 2^n - 2)$ voltage comparatos to convert the analog input voltage $V_{in}$ to digital outputs of (m + n) bits thus resulting in a smaller chip size and power consumption.

But, this serial-to-parallel A/D converter shown in Figure 2 requires the D/A converter 3. In addition, if there exists an error between the output of the more significant bit converting A/D converter 2 at the first stage and the output of the D/A converter 3, this error appears directly as a conversion error, and hence an error will occur at the connected portion between the more and less significant bit outputs. In other words, when the analog input voltage $V_{in}$ is increased, for example, monotonically, the digital output dips at the point where the digital output is carried from the less significant bit to the more significant bit, and thereafter the digital output is not increased monotonically.

In order to remove the defects inherent in the serial-to-parallel type A/D converter, we have previously proposed an improved A/D converter shown in Figure 3 of the accompanying drawings. The improved A/D converter omits the D/A converter 3 and the differential amplifier 4 used in the A/D converter shown in Figure 2. The less significant 4-bit A/D converter 5 is controlled by the control pulse provided on the basis of the converter output of the more significant 4-bit A/D converter 2.

Figure 4 of the accompanying drawings shows a practical example of such an A/D converter and in this example, the four bit conversion is carried out. In Figure 4, a more significant 2-bit A/D converter 6 is formed of three voltage comparator circuits $M_1$ to $M_3$ and an encoder 7, while a less significant 2-bit A/D converter 8 is formed of three voltage comparator circuits $N_1$ to $N_3$ and an encoder 9.

A predetermined voltage is applied across terminals 11 and 12 between which sixteen voltage-dividing resistors R, each having an equal resistance value, are connected in series. Reference voltages $V_{15}$ to $V_0$ of sixteen steps generated by these resistors R are divided into four groups of $V_{15}$ to $V_{12}$, $V_{11}$ to $V_8$, $V_7$ to $V_4$ and $V_3$ to $V_0$. The voltages $V_{12}$, $V_8$, $V_4$ (and $V_0$), each of which represents each group are compared in voltage with the analog input voltage $V_{in}$ and then two more significant bits, $D_3$ and $D_2$ in the digital output are produced. In correspondence with the two more significant bits $D_3$ and $D_2$, the voltage groups $V_k$ to $V_{k-3}$ (k = 15, 11 and 7) are selected. The voltages $V_k$ to $V_{k-3}$ of the selected groups are compared in voltage with the analog input voltage $V_{in}$, and then two less significant bits $D_1$ and $D_0$ of the digital output are produced.

The voltage groups $V_k$ to $V_{k-3}$ are selected by the encoder 7, more

particularly, outputs $P_3$ to $P_0$ are supplied thereto from the voltage comparator circuits $M_1$ to $M_3$. In order to supply the selected voltage groups to the less significant 2-bit converting voltage comparator circuits $N_1$ to $N_3$, there are provided differential switches SW as shown in Figure 4. The switch SW is formed of a differential amplifier.

Figure 5 of the accompanying drawings shows a practical example of the serial-to-parallel type A/D converter including the differential switches SW. Figure 5 is formed of Figures 5A and 5B. Each of the comparator circuits $M_3$ to $M_1$ is constructed such that the emitters of transistors $Q_{m1}$ and $Q_{m2}$ are connected together to a constant current source $S_m$, while each of the comparator circuits $N_3$ to $N_1$ is constructed such that the emitters of transistors $Q_{n1}$ and $Q_{n2}$ are connected together to a constant current source $S_n$.

Each differential switch SW is formed of a voltage comparator circuit $A_{ij}$ (where i is equal to a number from four to one and j is equal to a number from three to one). Each of the voltage comparator circuits $A_{ij}$ is constructed such that the emitters of transistors $Q_1$ and $Q_2$ are connected together to the collector of a current switching transistor $Q_3$. Inherently, the voltage comparator circuits $A_{i3}$ to $A_{i1}$ respectively operate as the first stage of the comparator circuits $N_3$ to $N_1$.

Of these 16-step reference voltages $V_{15}$ to $V_0$, the voltages $V_{12}$, $V_8$ and $V_4$ of every fourth step are respectively supplied to the bases of the transistors $Q_{m1}$ in the comparator circuits $M_3$ to $M_1$, and the voltages $V_{15}$ to $V_{13}$ and $V_7$ to $V_5$ are respectively supplied to the bases of the transistors $Q_2$ in the comparator circuits $A_{4j}$ and $A_{2j}$. The remaining voltages $V_9$ to $V_{11}$ and $V_1$ to $V_3$ are respectively supplied to the bases of the transistors $Q_1$ of the comparator circuits $A_{3j}$ and $A_{ij}$. To the bases of the transistors $Q_{m2}$ of the comparator circuits $M_3$ to $M_1$ and to the bases of the transistors in the transistors $Q_1$ and $Q_2$ of the voltage comparator circuits $A_{ij}$, which are not yet supplied with the voltages $V_{15}$ to $V_1$, is supplied the analog input voltage $V_{in}$.

The collector output $P_3$ of the transistor $Q_{m1}$ in the comparator circuit $M_3$ is supplied to the bases of the transistor $Q_3$ of the voltage comparator circuit $A_{4j}$. A wired-AND output $P_2$ between the outputs of the transistor $Q_{m2}$ in the comparator circuit $M_3$ and the transistor $Q_{m1}$ in the comparator $M_2$ is supplied to the bases of the transistors $Q_3$ of the

comparator $A_{3j}$. A wired-AND output $P_1$ between the outputs of the transistor $Q_{m2}$ of the comparator circuit $M_2$ and the transistor $Q_{m1}$ in the comparator circuit $M_1$ is supplied to the bases of the transistors $Q_3$ in the comparator circuit $A_{2j}$, and the collector output $P_0$ of the transistor $Q_{m2}$ in the comparator circuit $M_1$ is supplied to the bases of the transistors $Q_3$ in the comparator circuit $A_{1j}$.

The emitters of the transistors $Q_3$ in the comparator circuits $A_{i3}$ to $A_{i1}$ are connected to constant current sources $S_3$, $S_2$ and $S_1$ commonly. Also, the outputs $P_3$ to $P_1$ of the comparator circuits $M_3$ to $M_1$ are supplied to the more significant bit encoder 7 which derives the two more significant bits $D_3$ and $D_2$ of the digital outputs.

Moreover, the collectors of the transistors $Q_1$ and $Q_2$ of the comparator circuits $A_{i3}$ to $A_{ij}$ are respectively connected to the bases of the transistors $Q_{n1}$ and $Q_{n2}$ in the comparator circuits $N_3$ to $N_1$ commonly. A collector output $B_3$ of the transistor $Q_{n1}$ in the comparator circuit $N_3$, a wired-AND output $B_2$ between the outputs of the transistor $Q_{n2}$ in the comparator circuit $N_3$ and the transistor $Q_{n1}$ in the comparator circuit $N_2$ and a wired-AND output $B_1$ between the outputs of the transistor $Q_2$ in the comparator circuit $N_2$ and the transistor $Q_{n1}$ in the comparator circuit $N_1$ are all supplied to the less significant bit encoder 9 which is supplied with the bit $D_2$ from the encoder 7, so that the encoder 9 produces the two less significant bits $D_1$ and $D_0$ of the digital outputs. An example of each of truth tables of the encoders 7 and 9 is shown in Figures 6 and 7 of the accompanying drawings.

With the arrangement thus formed, as, for example, shown by a point (1) in Figures 5A and 5B, let it be assumed that the analog input voltage $V_{in}$ is less than the reference voltage $V_7$ and greater than the reference voltage $V_6$ (hereinafter, corresponding to the above point (1), characters "H" and "L", both showing the level of the signal are suffixed with 1 as in "$H_1$" and "$L_1$").

Then, since the analog input voltage $V_{in}$ is less than the reference voltage $V_8$ and less than the reference voltage $V_{12}$, the bases of the transistors $Q_{m1}$ in the comparator circuits $M_3$ and $M_2$ become "$H_1$" and the bases of the transistors $Q_{m2}$ thereof becomes "$L_1$", so that the collectors of the transistors $Q_{m1}$ thereof become "$L_1$" and the collectors of the transistors $Q_{m2}$ thereof become "$H_1$". Also, since the analog input voltage

$V_{in}$ is greater than the reference voltage $V_4$, the base of the transistor $Q_{m1}$ in the comparator circuit $M_1$ becomes "$L_1$" and the base of the transistor $Q_{m2}$ thereof becomes "$H_1$" so that the collector of its transistor $Q_{m1}$ becomes "$H_1$" and the collector of its transistor $Q_{m2}$ becomes "$L_1$". Accordingly, since the collector output $P_3$ is equal to "$L_1$", the collector output $P_2$ is equal to "$L_1$", the collector output $P_1$ is equal to "$H_1$" and the collector output $P_0$ is equal to "$L_1$", from the truth table of Figure 6, the bit $D_3$ is equal to "0" and the bit $D_2$ is equal to "1".

Whereas, since the collector output $P_3$ is equal to "$L_1$", the collector output $P_2$ is equal to "$L_1$", the collector output $P_1$ is equal to "$H_1$" and the collector output $P_0$ is equal to "$L_1$", only the transistors $Q_3$ of the comparator $A_{2j}$ are made ON, so that the analog input voltage $V_{in}$ is compared with the reference voltages $V_7$ to $V_5$ in the comparator circuit $A_{2j}$. Since the analog input voltage $V_{in}$ is less than the reference voltage $V_7$ and is greater than the reference voltage $V_6$, the base of the transistor $Q_1$ of the comparator circuit $A_{23}$ becomes "$L_1$" and the base of the transistor $Q_2$ thereof becomes "$H_1$" so that the collector of its transistor $Q_2$ becomes "$L_1$". Likewise, while the bases of the transistors $Q_1$ in the comparator circuits $A_{22}$ and $A_{21}$ becomes "$H_1$" and the bases of the transistors $Q_2$ thereof become "$L_1$", the collectors of the transistors $Q_1$ thereof become "$L_1$ and the collectors of the transistors $Q_2$ thereof become "$H_1$.

Since these outputs are supplied to the comparator circuits $N_3$ to $N_1$, the collector of the transistor $Q_{n1}$ in the comparator circuit $N_3$ becomes "$L_1$" and the collector of the transistor $Q_{n2}$ thereof becomes "$H_1$", while the collectors of the transistors $Q_{n1}$ in the comparator circuits $N_2$ and $N_1$ both become "$H_1$" and the collectors of the transistors $Q_{n2}$ thereof become "$L_1$". Accordingly, the collector output $B_3$ is equal to "$L_1$", the collector output $B_2$ is equal to "$H_1$" and the collector output $B_1$ is equal to "$L_1$", and at the same time, the bit $D_2$ is equal to "1". Therefore, from the truth table of Figure 7, the bit $D_1$ is equal to "1" and the bit $D_0$ is equal to "0".

Therefore, when the analog input voltage $V_{in}$ is less than the reference voltage $V_7$ and is greater than the reference voltage $V_6$ as shown by the point (1), the digital outputs $D_3$ to $D_0$ thus obtained are represented by "0 1 1 0". When the analog input voltage $V_{in}$ at this time whose fractions are omitted is quantized, it has the level of the sixth step counting from the grounded side (the grounded electric potential is numbered as the zero step). Thus since six is represented as "0 1 1 0", the digital outputs $D_3$ to $D_0$ are equal to "0 1 1 0" so that they are the correct digital outputs.

As shown, for example, by a point ② in Figure 5A, let it be assumed that the analog input voltage $V_{in}$ is less than the reference voltage $V_{10}$ and is greater than the reference voltage $V_9$ (hereinafter, characters "H" and "L" indicating the level of the signal are suffixed by "2" in respect of the point ② ).

Then, since the analog input voltage $V_{in}$ is less than the reference voltage $V_{12}$, the base of the transistor $Q_{m1}$ in the comparator circuit $M_3$ becomes "$H_2$" and the base of the transistor $Q_{m2}$ thereof becomes "$L_2$" so that the collector of the transistor $Q_{m1}$ thereof becomes "$H_2$". In addition, since the analog input voltage $V_{in}$ is greater than the reference voltage $V_4$ and is further greater than the reference voltage $V_8$, the bases of the transistors $Q_{m1}$ in the comparator circuits $M_2$ and $M_1$ become "$L_2$" and the bases of the transistors $Q_{m2}$ thereof become "$H_2$, so that the collectors of the transistor $Q_{m1}$ thereof become "$H_2$" and the collectors of the transistors $Q_{m2}$ become "$L_2$". Therefore, since the collector output $P_3$ is equal to "$L_2$", the collector output $P_2$ is equal to "$H_2$", the collector output $P_1$ is equal to "$L_2$" and the collector output $P_0$ is equal to "$L_2$", from the truth table of Figure 6, the digital output $D_3$ is equal to "1" and the digital output $D_2$ is equal to "0".

While, since the collector output $P_3$ is equal to "$L_2$", the collector output $P_2$ is equal to "$H_2$", the collector output $P_1$ is equal to "$L_2$" and the collector output $P_0$ is equal to "$L_2$", only the transistor $Q_3$ in the comparator circuit $A_{3j}$ is made ON, so that the input voltage $V_{in}$ is compared with the reference voltages $V_9$ to $V_{11}$ in the comparator circuit $A_{3j}$. Since the input voltage $V_{in}$ is greater than the reference voltage $V_9$ and is less than the reference voltage $V_{10}$, the base of the transistor $Q_1$ of the comparator circuit $A_{33}$ becomes "$L_2$" and the base of the transistor $Q_2$ thereof becomes "$H_2$" so that the collector of the transistor $Q_1$ thereof becomes "$H_2$" and the collector of the transistor $Q_2$ thereof becomes "$L_2$". Thus, at the same time, the bases of the transistors $Q_1$ in the comparator circuits $A_{32}$ and $A_{31}$ become both "$H_2$" and the bases of the transistors $Q_2$ thereof become both "$L_2$", so that the collectors of the transistors $Q_1$ become "$L_2$" and the collectors of the transistors $Q_2$ become "$H_2$".

Since these outputs are supplied to the comparator circuits $N_3$ to $N_1$, while the collector of the transistor $Q_{n1}$ in the comparator circuit $N_3$ becomes "$L_2$" and the collector of the transistor $Q_{n2}$ thereof becomes "$H_2$", the collectors of the transistors $Q_{n1}$ in the comparator circuits $N_2$ and $N_1$ become "$H_2$" and the collectors of the transistors $Q_{n2}$ thereof become "$L_2$". Therefore, since the output $B_3$ is equal to "$L_2$", the output $B_2$ is equal to "$H_2$" and the output $B_1$ is equal to "$L_2$" and also the digital output $D_2$ is equal to "0", from the truth table of Figure 7, the digital output $D_1$ is equal to "0" and the digital output $D_0$ is equal to "1".

Accordingly, when the analog input voltage $V_{in}$ is less than the reference voltage $V_{10}$ and is greater than the reference voltage $V_9$ as shown by the point ②, the digital outputs $D_3$ to $D_0$ become as represented by "1 0 0 1". If the input voltage $V_{in}$ at that time whose fractions are omitted is quantized, it has the level of ninth step counting from the grounded side. In this case, nine is equal to "1 0 0 1", so that the digital outputs $D_3$ to $D_0$ are equal to "1 0 0 1", proving that they are the correct digital outputs.

When the comparator circuits $N_3$ to $N_1$ provided in the less significant 2-bit A/D converter 8 are not formed merely by only the differential amplifiers as mentioned above, but are formed in such a manner that the compared outputs $B_3$ to $B_1$, which are the outputs from the differential amplifiers, are latched once or temporarily and the latched outputs are then supplied to the encoder 9, instead of the comparator circuits $N_3$ to $N_1$, latched comparators are used.

Figure 8 of the accompanying drawings is a circuit diagram showing an example of the latch comparator circuit, which corresponds to the comparator circuit $N_2$. In Figure 8, references the same as those in Figure 5 designate the same elements. In Figure 8, reference numeral 20 generally designates the latched comparator circuit in which there is provided in addition to the voltage comparator circuit $N_2$, a latch circuit 21 for latching the output of the comparator circuit $N_2$.

The latch circuit 21 includes a pair of transistors Qa and Qb in which the emitters thereof are connected in common, and the base of one transistor is connected to the collector of the other transistor and vice versa. The collector output (compared output) $B_2$ of the transistor $Q_{n1}$ in the comparator circuit $N_2$ is supplied to the base of one transistor Qb, while the other collector output $B_1$ is supplied to the base of the other transistor Qa.

The comparator circuit $N_2$ and the latch circuit 21 are controlled complementarily in their operations. To this end, there is provided a switching differential amplifier 22 formed of a pair of transistors Qc and Qd which is controlled in switching operation in response to pulses Pc and $\overline{Pc}$ (each of which is synchronized with the sampling pulse) to be respectively supplied to the transistors Qc and Qd. Reference numeral 23 designates a current source and Ra and $R_L$ collector resistors of the voltage comparator circuit $A_{i2}$ and the comparator circuit $N_2$, respectively.

With the above construction, when the pulse Pc is at high level, the comparing operation is carried out in the latched comparator circuit 20, while when the pulse Pc is at low level, the compared output is latched therein.

When the latched comparator circuit 20 is used as described above, after the input voltage $V_{in}$ and the reference voltage $V_n$ are compared in voltage by the voltage comparator circuits $A_{i2}$, the voltage comparing operation is carried out by the comparator circuit $N_2$. As a result, the compared outputs $B_1$ and $B_2$ are delayed by the time necessary for the comparing operation in the comparator circuit $N_2$ at the succeeding stage. Thus, the sampling period of the A/D converter cannot be made short and hence high speed A/D conversion is prevented.

In addition, when a DC offset exists in the comparator circuit $N_2$ which serves as the last stage differential amplifying section for the encoder 9, since usually no means of adjusting the DC offset is provided, the accuracy of the A/D conversion becomes poor.

According to the present invention there is provided a latched comparator circuit in which a voltage comparing operation and a latch operation are repeatedly carried out at every sampling period, the circuit comprising:

a plurality of voltage comparators supplied with one analog input signal commonly and a plurality of different reference voltages respectively, one of said plurality of voltage comparators being selected at every sampling period and output terminals of said voltage comparators being connected in common; and

a latch circuit directly supplied with a common output of said plurality of voltage comparators and carrying out a latch operation in synchronism with a sampling period, an output terminal of said latch circuit being commonly connected to said voltage comparators and also being connected through a resistor to a power source.

According to the present invention there is also provided an analog to digital converter for converting an analog input signal to a digital signal, the converter comprising:

a resistor group formed of a plurality of resistors connected in series for generating reference voltages;

a plurality of first voltage comparator circuits for comparing said analog input signal with a reference voltage at every M<u>th</u> resistor in said resistor group;

a plurality of second voltage comparator circuits for comparing said analog input signal with a reference voltage at every N<u>th</u> resistor in said resistor group;

selecting means for selecting from the outputs of said first voltage comparator circuits a reference voltage which is to be supplied to said second voltage comparator circuits;

a first encoder for forming a first digital output from the outputs of said first voltage comparator circuits;

a second encoder for forming a second digital output from the outputs of said second voltage comparator circuits; and

mixing means for mixing said first digital output and said second digital output to produce a digital output signal corresponding to said analog input signal;

wherein at least either of said first and second voltage comparator circuits are formed of a latched comparator circuit and said latched comparator circuit carries out a voltage comparing operation and a latch operation repeatedly at every sampling period, said latched comparator circuit comprising:

a plurality of voltage comparators supplied with one analog input signal commonly and a plurality of different reference voltages respectively, one of said plurality of voltage comparators being selected at every sampling period and output terminals of said voltage comparators being connected in common; and

a latch circuit directly supplied with a common output of said plurality of voltage comparators and carrying out a latch operation in synchronism with the sampling period, an output terminal of said latch circuit being commonly connected to said voltage comparators and also connected through a resistor to a power source.

The invention will now be described by way of example with reference to the accompanying drawings, throughout which like parts are referred to by like references, and in which:

Figure 1 is a diagram for explaining a conventional parallel type A/D converter;

Figure 2 is a diagram for explaining a conventional serial-to-parallel type A/D converter;

Figure 3 is a diagram showing an example of an improved serial-to-parallel type A/D converter which is used to explain the present invention;

Figure 4 is a block diagram showing part of a practical example thereof;

Figure 5 (formed of Figures 5A and 5B) is a circuit diagram showing the construction of Figure 4 in more detail;

Figures 6 and 7 are truth tables of an encoder used in the A/D converter of Figure 3;

Figure 8 is a circuit diagram of a latched comparator circuit used to explain the present invention;

Figure 9 is a circuit diagram showing an embodiment of latched comparator circuit according to the present invention; and

Figure 10 is a circuit diagram showing another embodiment of the latched comparator circuit according to the present invention.

Now, embodiments of latched comparator circuit according to the present invention will be described with reference to Figures 9 and 10, in which the same references as those in Figure 8 designate the same elements in the case where the embodiment of the invention is used as the comparator of the A/D converter as an example.

In the first embodiment, as shown in Figure 9, the collector outputs of the voltage comparator circuits $A_{i2}$ are, as they are, supplied to the latch circuit 21 so that the collector resistors Ra and the comparator circuit $N_2$ used in the example shown in Figure 8 are not necessary. Thus, the collector of the transistor Qc is directly connected to a power source Vcc. The other circuit construction of this embodiment is substantially the same as that of the example shown in Figure 8.

With the embodiment thus constructed, the collector outputs compared in voltage by the voltage comparator circuits $A_{i2}$ are latched in the latch circuit 21 in response to the supply of the pulse $\overline{Pc}$ thereto. Accordingly, since the comparator circuit $N_2$ is not provided, the delay time is reduced by the amount corresponding to the delay time caused by the comparator circuit $N_2$ so as to make the comparing speed high. Thus, a frequency of more than 80 MHz can be used as the sampling frequency, so that the A/D conversion can be done quickly. Also, the embodiment is free of the problem of DC offset.

When the latched comparator circuit is formed as shown in Figure 9, a capacitance such as a collector parasitic capacitance $C_S$ between the collectors of the transistors $Q_1$ and $Q_2$ and the IC substrate, a collector-base capacitance $C_{CB}$, a line capacitance $C_L$ and the like is interposed in parallel with the load resistor $R_L$. Due to the time constant determined by the total capacitance thereof and the resistance value of the load resistor $R_L$, signal delay is caused between the voltage comparator circuits $A_{i2}$ and the latch circuit 21. Particularly when a large number of voltage comparator circuits $A_{i2}$ are connected in parallel as shown in Figure 9, the total capacity becomes as large as the integral multiple of the number of the voltage comparator circuits $A_{i2}$ so that the time constant becomes larger and hence the delay of the signal also becomes larger.

Therefore, although the voltage comparator circuit $N_2$ is omitted from the circuitry as above so as to prevent the signal from being delayed, it cannot be said that this above delay preventing measure is sufficient.

Figure 10 shows another embodiment of latched comparator circuit according to the present invention which is improved in respect of the above points relative to the embodiment of Figure 9. In this case, transistors Qi and Qj which are connected in cascade are respectively provided for the transistors $Q_1$ and $Q_2$ forming the voltage comparator circuits $A_{i2}$, and through the transistors Qi and Qj, the differential collector outputs are supplied to the latch circuit 21. The other circuit construction of the embodiment shown in Figure 10 is substantially the same as that shown in Figure 9.

With this embodiment, a line time constant is determined by the emitter resistance re of the cascade-connected transistors Qi and Qj and the above total capacitance. Since the emitter resistance re is decreased in proportion to the emitter current which flows through the cascade-connected transistors Qi and Qj, the condition of re is much less than $R_L$ is satisfied. Consequently, when the cascade-connected transistors Qi and Qj are connected as above, the influence of the load resistor $R_L$ is removed, and the time constant becomes significantly smaller, so that the delay in the signal line up to the latch circuit 21 can be improved greatly.

As described above, the delay of the signal can be improved considerably by this embodiment of the latched comparator circuit and hence it is appreciated that a higher speed than that of Figure 9 can be attained in A/D conversion.

While in the above description the present invention is applied to a latched comparator circuit for the high speed A/D converter, the present invention can also be applied to a circuit in which a large number of differential amplifying circuits which are connected in parallel are connected to the input stage of the latched comparator circuit.

While in the above description the operation is given for four bit operation, the present invention can be applied without any limitation to the number of bits. While in the above embodiments the present invention is applied to a latched comparator circuit for the comparator circuit $N_2$, the invention can naturally be applied to a latched comparator circuit for the other comparator circuits $N_3$ and $N_1$.

Thus, as described, some circuits are used in common to remove the delay of the signal and thereby to enable the A/D conversion to be done at high speed. At the same time, the occurrence of the DC offset is reduced, so that the accuracy of the A/D conversion can be improved. In addition, if the latched comparator circuit is constructed as shown in Figure 10, the A/D conversion can be carried out at higher speed.

CLAIMS

1. A latched comparator circuit in which a voltage comparing operation and a latch operation are repeatedly carried out at every sampling period, the circuit comprising:
a plurality of voltage comparators ($A_{i2}$) supplied with one analog input signal commonly and a plurality of different reference voltages respectively, one of said plurality of voltage comparators being selected at every sampling period and output terminals of said voltage comparators ($A_{i2}$) being connected in common; and
a latch circuit (21) directly supplied with a common output of said plurality of voltage comparators ($A_{i2}$) and carrying out a latch operation in synchronism with a sampling period, an output terminal of said latch circuit (21) being commonly connected to said voltage comparators ($A_{i2}$) and also being connected through a resistor ($R_L$) to a power source (Vcc).

2. A latched comparator circuit according to claim 1 wherein each of said voltage comparators ($A_{i2}$) is formed of a pair of transistors ($Q_1$, $Q_2$) of the same polarity, bases of said transistors ($Q_1$, $Q_2$) being respectively supplied with an analog input signal and a reference voltage and emitters of said transistors ($Q_1$, $Q_2$) being connected in common and grounded through a first switching circuit ($Q_3$) which is switched at the sampling period, and said voltage comparator ($A_{12}$) supplies a compared result of said analog input signal with said reference voltage at collectors thereof at every sampling period.

3. A latched comparator circuit according to claim 1 wherein said latch circuit (21) is formed of a pair of transistors (Qa, Qb), emitters of said pair of transistors (Qa, Qb) being connected in common, a base of one transistor (Qa) being connected to a collector of the other transistor (Qb) and vice versa, bases of said pair of transistors (Qa, Qb) being respectively connected to the output terminals of said voltage comparators ($A_{i2}$) and said common emitters being grounded through a series circuit formed of a second switching circuit (Qc, Qd) which is switched at sampling period and a constant current source (23).

4. A latched comparator circuit according to claim 3 wherein said second switching circuit (Qc, Qd) is formed of a pair of transistors (Qc, Qd) connected in differential construction, bases of said pair of transistors (Qc, Qd) being respectively supplied with pulses synchronised with the sampling frequency and of different phases, a collector of one (Qd) of said pair of transistors (Qc, Qd) being connected to the common emitters of said transistors (Qa, Qb) forming said latch circuit (21) and a collector of the other (Qc) of said pair of transistors (Qc, Qd) being connected to a power source (Vcc).

5. A latched comparator circuit according to claim 1 wherein the common output terminal of each of said plurality of voltage comparators ($A_{i2}$) are connected through a pair of transistors (Qi, Qj) of the same polarity connected in cascade to said latch circuit (21).

6. A latched comparator circuit according to claim 2 wherein the collectors of each of said plurality of voltage comparators ($A_{i2}$) are connected to emitters of a pair of transistors (Qi, Qj) of the same polarity connected in cascade and collectors of said pair of transistors (Qi, Qj) connected in cascade are respectively connected to said latch circuit (21).

7. An analog to digital converter for converting an analog input signal to a digital signal, the converter comprising:
a resistor group formed of a plurality of resistors (R) connected in series for generating reference voltages;
a plurality of first voltage comparator circuits ($M_1$, etc) for comparing said analog input signal with a reference voltage at every Mth resistor (R) in said resistor group;
a plurality of second voltage comparator circuits ($N_1$, etc) for comparing said analog input signal with a reference voltage at every Nth resistor (R) in said resistor group;
selecting means (SW) for selecting from the outputs of said first voltage comparator circuits ($M_1$, etc) a reference voltage which is to be supplied to said second voltage comparator circuits ($N_1$, etc);
a first encoder (7) for forming a first digital output from the outputs of said first voltage comparator circuits($M_1$, etc);

a second encoder (9) for forming a second digital output from the outputs of said second voltage comparator circuits ($N_1$, etc); and

mixing means for mixing said first digital output and said second digital output to produce a digital output signal corresponding to said analog input signal;

wherein at least either of said first and second voltage comparator circuits ($M_1$, etc, $N_1$, etc) are formed of a latched comparator circuit and said latched comparator circuit carries out a voltage comparing operation and a latch operation repeatedly at every sampling period, said latched comparator circuit comprising:

a plurality of voltage comparators ($Ai_2$) supplied with one analog input signal commonly and a plurality of different reference voltages respectively, one of said plurality of voltage comparators ($Ai_2$) being selected at every sampling period and output terminals of said voltage comparators ($Ai_2$) being connected in common; and

a latch circuit (21) directly supplied with a common output of said plurality of voltage comparators ($Ai_2$) and carrying out a latch operation in synchronism with the sampling period, an output terminal of said latch circuit (21) being commonly connected to said voltage comparators ($Ai_2$) and also connected through a resistor ($R_L$) to a power source (Vcc).

 

FIG. 1 (PRIOR ART)

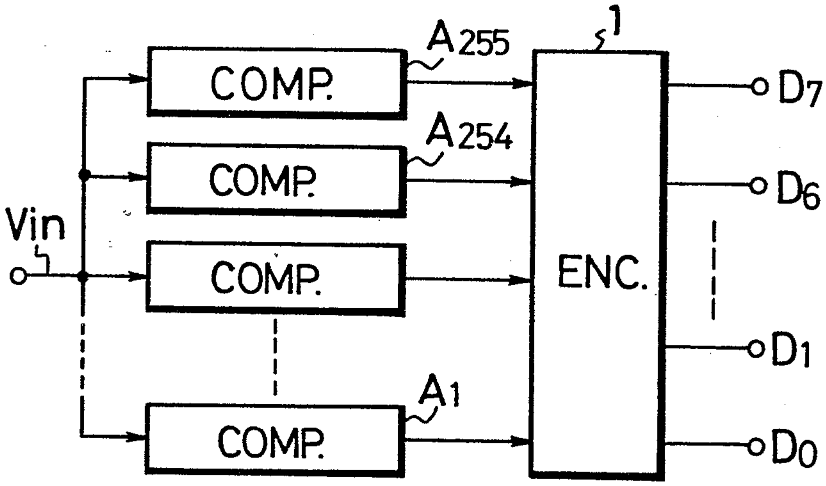


FIG. 2 (PRIOR ART)

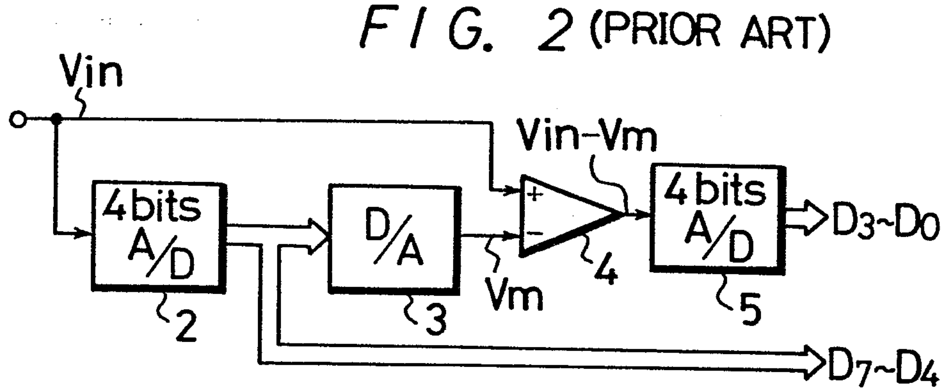


FIG. 3 (PRIOR ART)

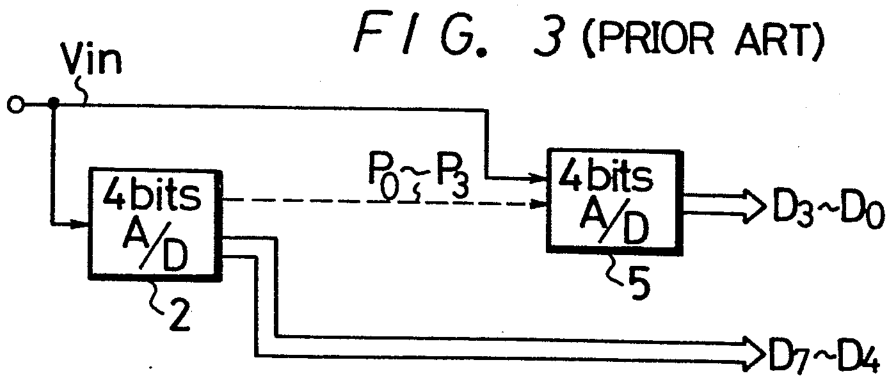

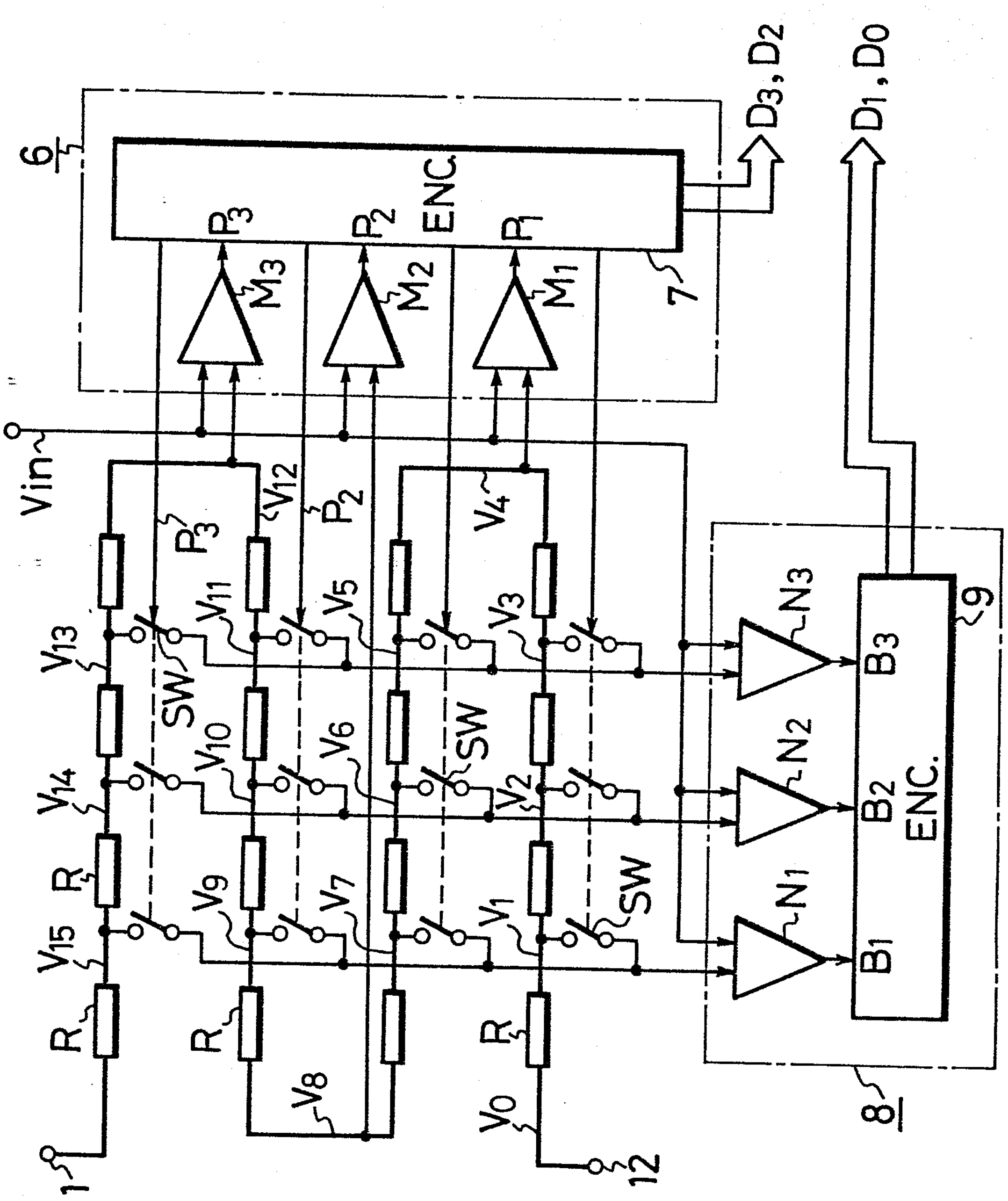

6
ENC
$P_3$
$P_2$
$P_1$
$M_3$
$M_2$
$M_1$
7
$D_3, D_2$
$D_1, D_0$
Vin
$V_{12}$
$P_3$
$P_2$
$V_4$
$V_{13}$
$V_{14}$
$V_{15}$
$V_{11}$
$V_{10}$
$V_9$
$V_5$
$V_6$
$V_7$
$V_3$
$V_2$
$V_1$
$V_8$
$V_0$
SW
R
11
12
$N_3$
$N_2$
$N_1$
$B_3$
$B_2$
$B_1$
ENC.
9
8


F I G. 4

0116776

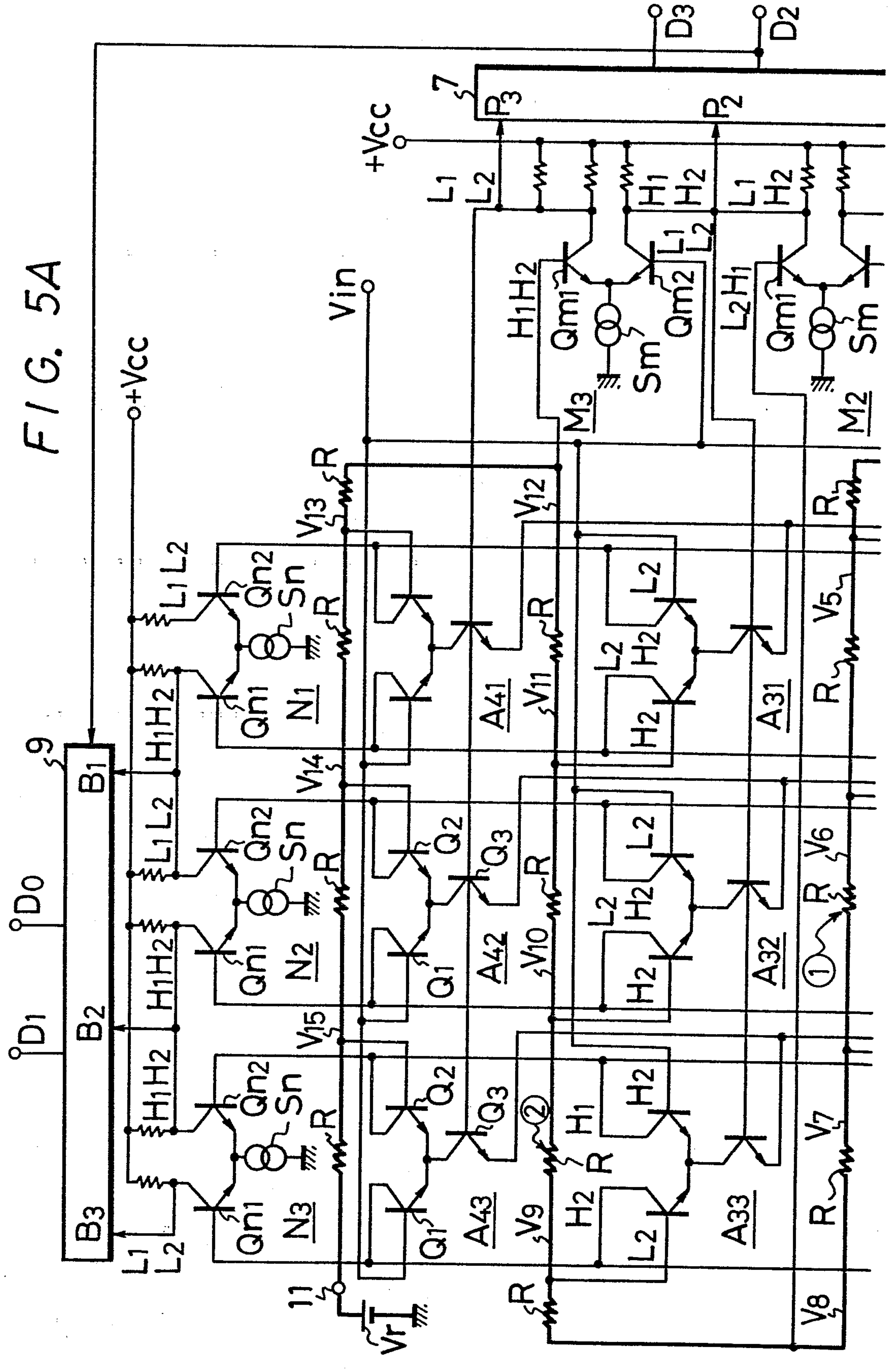


FIG. 5A

FIG. 5B

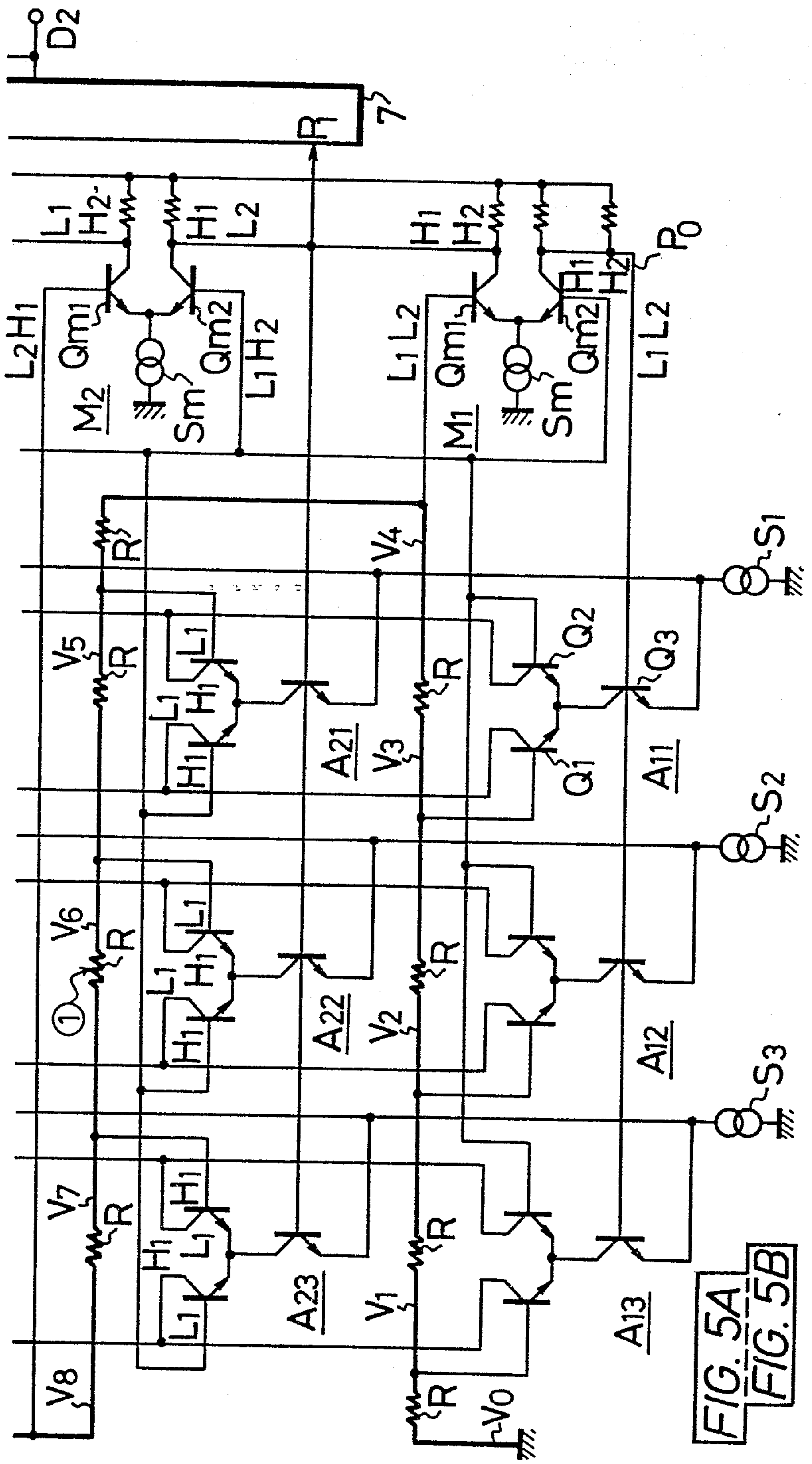
D2
7
R
L1 H2
H1 L2
L2 H1
Qm1
Qm2
Sm
M2
L1 H2
H1 H2
P0
L1 L2
M1
R
V4
V5
V6
V7
V8
V3
V2
V1
V0
A21
A22
A23
A11
A12
A13
Q1
Q2
Q3
S1
S2
S3
FIG. 5A
FIG. 5B

FIG. 6

| | $P_3$ | $P_2$ | $P_1$ | $P_0$ | $D_3$ | $D_2$ |
|---|---|---|---|---|---|---|
| | L | L | L | H | 0 | 0 |
| ① | L | L | H | L | 0 | 1 |
| ② | L | H | L | L | 1 | 0 |
| | H | L | L | L | 1 | 1 |

FIG. 7

| | $D_2$ | $B_3$ | $B_2$ | $B_1$ | $D_1$ | $D_0$ |
|---|---|---|---|---|---|---|
| | 0 | H | L | L | 0 | 0 |
| ② | 0 | L | H | L | 0 | 1 |
| | 0 | L | L | H | 1 | 0 |
| | 0 | L | L | L | 1 | 1 |
| | 1 | L | L | L | 0 | 0 |
| | 1 | L | L | H | 0 | 1 |
| ① | 1 | L | H | L | 1 | 0 |
| | 1 | H | L | L | 1 | 1 |

FIG. 8

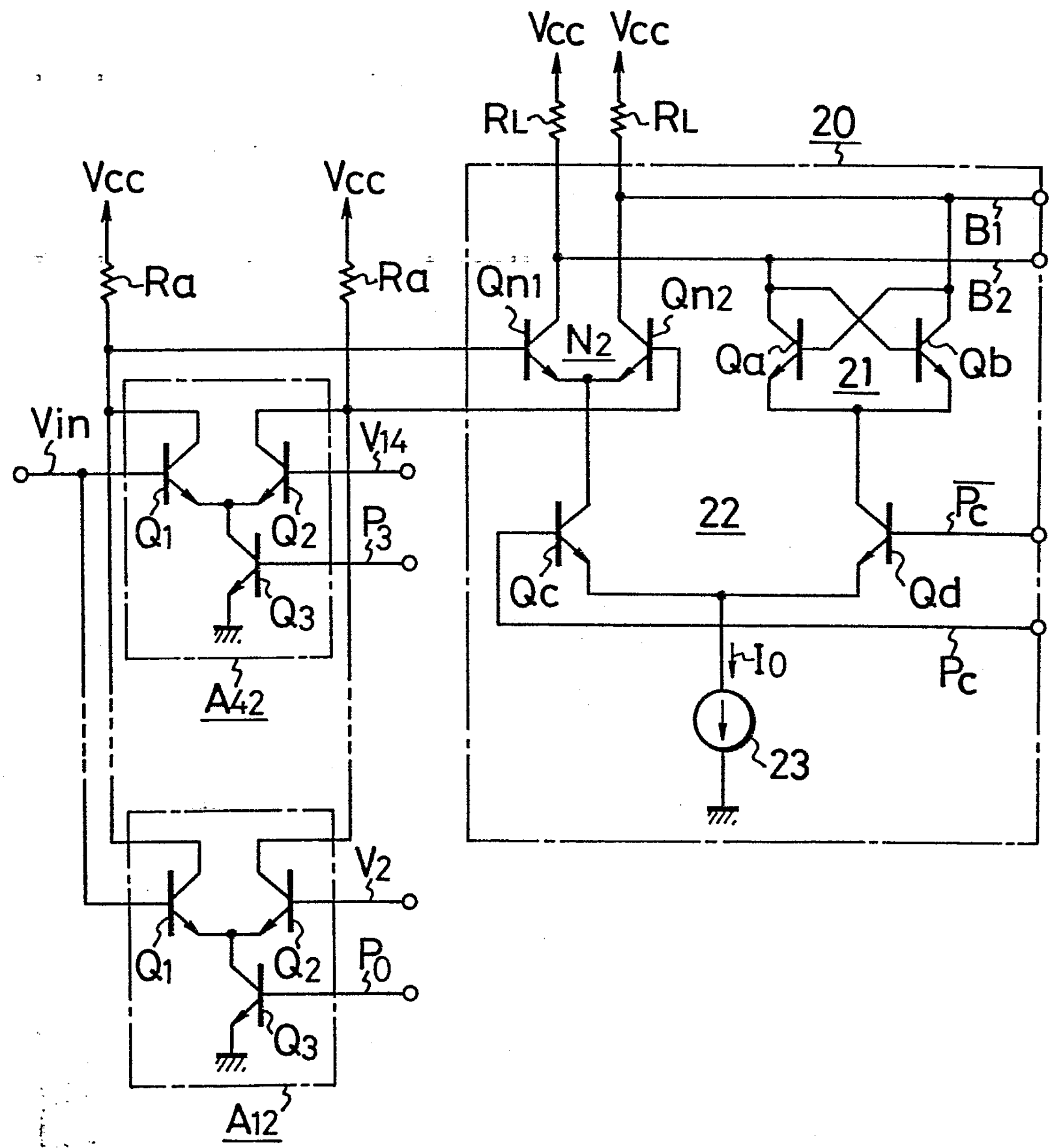
Vcc
Vcc
RL
RL
20
Vcc
Vcc
Ra
Ra
Qn1
Qn2
N2
B1'
B2'
Qa
21
Qb
Vin
V14
Q1
Q2
P3
Q3
A42
22
Pc
Qc
Qd
Pc
I0
23
V2
Q1
Q2
P0
Q3
A12

FIG. 9

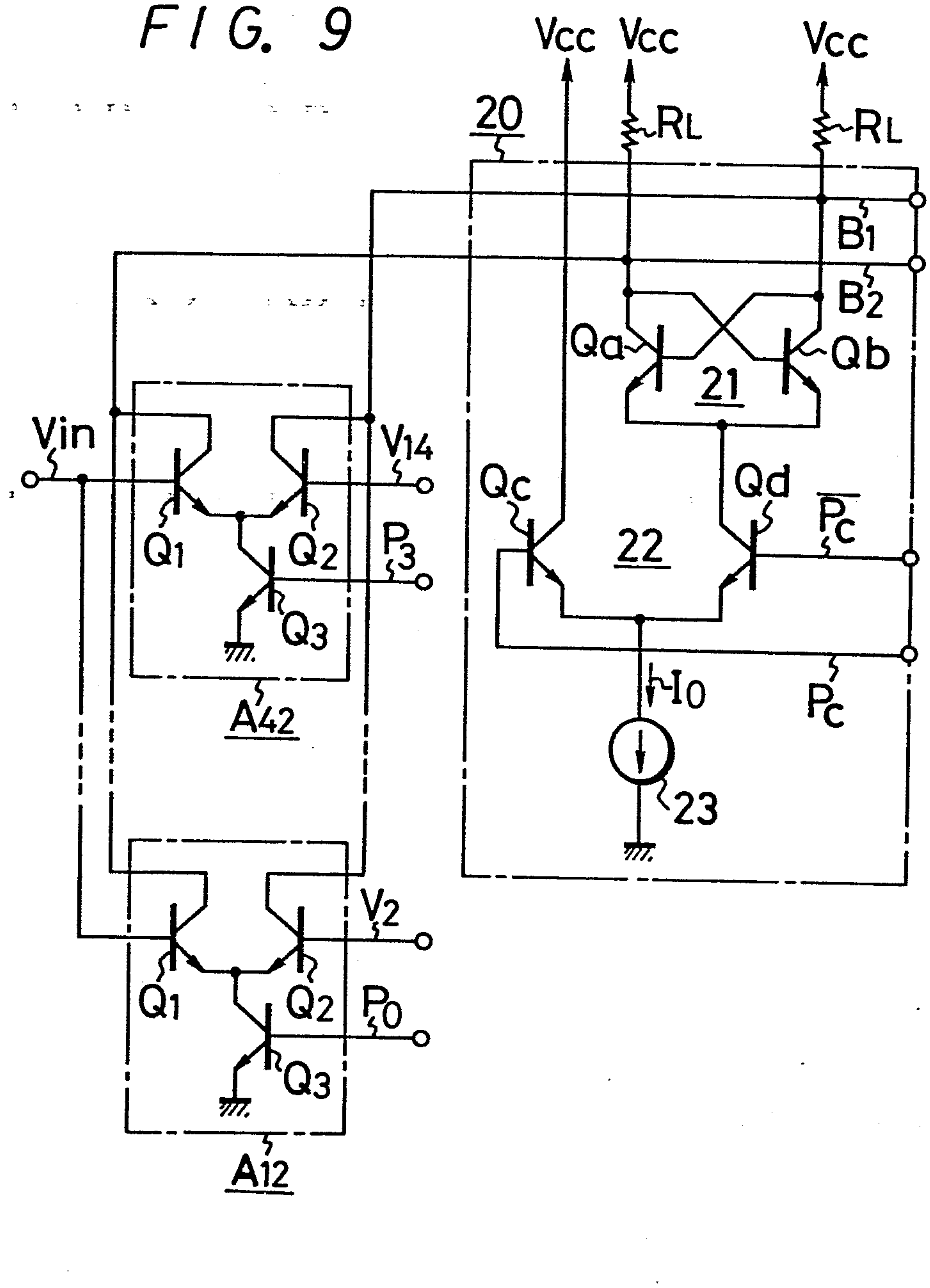
Vcc
Vcc
Vcc
20
RL
RL
B1
B2
Qa
Qb
21
Vin
V14
Qc
Qd
22
Q1
Q2
P3
Pc
Q3
Pc
I0
A42
23
V2
Q1
Q2
P0
Q3
A12

FIG. 10

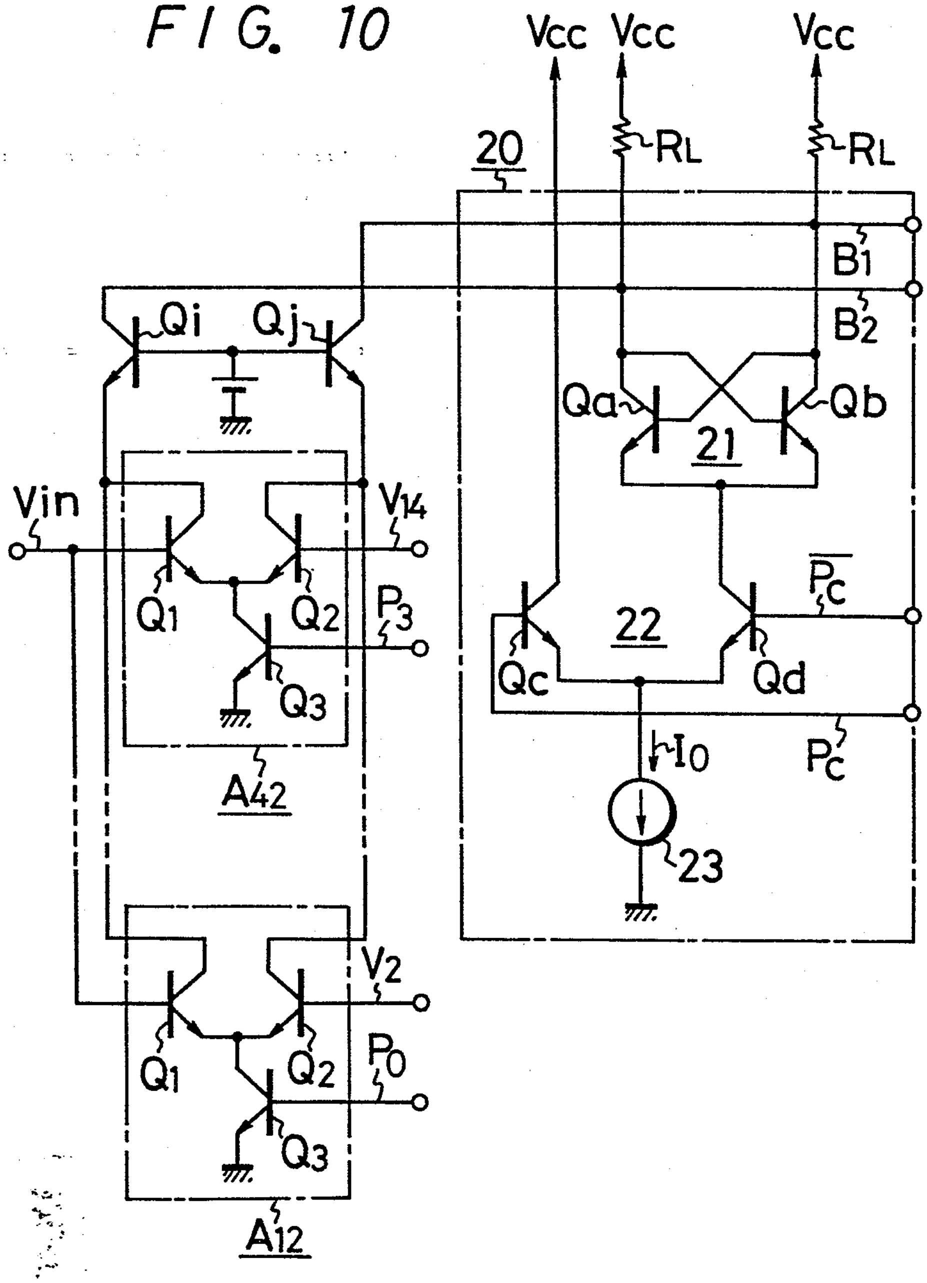
Vcc
Vcc
Vcc
RL
RL
20
B1
B2
Qi
Qj
Qa
Qb
21
Vin
V14
Q1
Q2
P3
Q3
A42
Pc
22
Qc
Qd
Pc
I0
23
V2
Q1
Q2
P0
Q3
A12

European Patent Office

# EUROPEAN SEARCH REPORT

0116776

Application number

EP 83 30 7808

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| | | | H 03 K 5/24<br>H 03 K 3/288<br>H 03 K 13/175 |
| Y | IEEE INTERNATIONAL SOLID-STATE CIRCUITS CONFERENCE, vol. 25, 10 February 1982, New York T. SEKINO et al. "A monolithic 8b two-step parallel ADC without DAC and subtractor circuits", pages 46, 47, 290<br>* Figure 2, middle column of primary comparators and middle fine comparator; page 46, left-hand column, lines 23-27 *<br>--- | 1 | |
| A | IEEE INTERNATIONAL SOLID STATE CIRCUITS CONFERENCE, vol. 25, 10 February 1982<br>* Figure 3 *<br>--- | 2 | |
| Y | IEEE INTERNATIONAL SOLID STATE CIRCUITS CONFERENCE, vol. 25, 10 February 1982<br>* Figure 2 *<br>--- | 7 | TECHNICAL FIELDS SEARCHED (Int. Cl. 3) |
| Y | US-A-3 953 746 (D.L. FETT)<br>* Figure 1; abstract *<br>--- | 1,7 | H 03 K 3/288<br>H 03 K 5/24<br>H 03 K 13/02<br>H 03 K 13/03<br>H 03 K 13/05<br>H 03 K 13/175<br>H 03 K 19/086 |
| A | IEEE JOURNAL OF SOLID-STATE CIRCUITS, vol. SC-14, no. 6, December 1979, New York R.J. VAN DE PLASSCHE et al. "A high-speed 7 bit A/D converter", pages 938-943r<br>* Figure 5 *<br>--- -/- | | |

The present search report has been drawn up for all claims

| Place of search | Date of completion of the search | Examiner |
|---|---|---|
| BERLIN | 21-03-1984 | ARENDT M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82

European Patent Office

0116776

Application number

# EUROPEAN SEARCH REPORT

EP 83 30 7808

Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | ELECTRO CONFERENCE RECORD, 1977 P.S. CROSBY "The design of a highly integrated 8-bit, 20 MHZ analog-to-digital converter for automatic measurements", pages 1-5 * Figures 2, 3 * | | |
| A | US-A-4 306 224 (W.L. GELLER et al.) * Figure 1 * | | |
| A,P | US-A-4 383 248 (G.J. SMITH) * Figure * | | |
| A | US-A-4 237 387 (D.C. DEVENDORF et al.) | | TECHNICAL FIELDS SEARCHED (Int. Cl. 3) |
| P,A | EP-A-0 070 734 (SONY CORP.) | | |
| P,A | EP-A-0 070 175 (SONY CORP.) | | |

The present search report has been drawn up for all claims

| Place of search | Date of completion of the search | Examiner |
|---|---|---|
| BERLIN | 21-03-1984 | ARENDT M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82